# EUROPEAN PATENT APPLICATION

(11) **EP 4 737 933 A1**
(43) Date of publication of application: **06.05.2026**
(21) Application number: 24210519.5
(22) Date of filing: 04.11.2024
(51) Int. Cl.: G01R 33/56, G01R 33/50, G01R 33/563

(54) **QUANTITATIVE MATERIAL CHARACTERIZATION OF AN OBJECT WITH MAGNETIC RESONANCE IMAGING**

(71) Applicant: Siemens Healthineers AG, 91301 Forchheim (DE); Friedrich-Alexander-Universität Erlangen-Nürnberg, 91054 Erlangen (DE)
(72) Inventor: Endres, Jonathan, 96047 Bamberg (DE); Nickel, Marcel Dominik, 91074 Herzogenaurach (DE); Pfaff, Laura, 90431 Nürnberg (DE); Weinmüller, Simon, 91054 Erlangen (DE); Würfl, Tobias, 91054 Erlangen (DE); Zaiss, Moritz, 90419 Nürnberg (DE)
(74) Representative: Siemens Healthineers Patent Attorneys

(57) **Abstract**

For material characterization, first and second measured MRI data (20, 23, 26) representing an object (6) and corresponding first and second sequence descriptions (21, 24, 27) are received. For each iteration, first and second simulated MRI data (22, 25, 28) is generated according to the sequence descriptions (21, 24, 27) based on a model (29) comprising model values for at least one material parameter. An error (31) is determined, which depends on a deviation of the simulated MRI data (22, 25, 28) from the measured MRI data (20, 23, 26). The model (29) is adapted depending on the error (31). For an initial iteration, the model (29) corresponds to an initial model (29) and otherwise it corresponds to the adapted model (29) of the preceding iteration. The quantitative material characterization is determined depending on the adapted model (29) of a final iteration of the two or more iterations.

## Description

The present invention is directed to a computer-implemented method for determining a quantitative material characterization of an object, wherein first measured magnetic resonance imaging, MRI, data representing the object is received. The invention is further directed to a data processing system for carrying out said computer-implemented method, to a corresponding method for quantitative MRI, to an MRI system comprising said data processing system, and to corresponding computer program products.

Quantitative MRI, qMRI, plays an important role in medical imaging by providing quantitative, objective measurements of tissue properties, such as relaxation times or proton density. Unlike conventional MRI, which produces images with qualitative contrasts only, qMRI aims to derive material parameters that have direct relevance to the underlying tissue composition and microstructure. This shift towards quantification enhances the precision and reproducibility of MRI examinations and facilitates comparisons across different subjects and scanners.

Various approaches have been suggested for the quantification of tissue parameters. However, most of them require excessive scan time, which poses challenges for their practical implementation in clinical settings and provides limited reproducibility.

In acquisition processes, parametric mapping frequently involves a delicate balance between precision and accuracy versus the time required for measurement. Precise and accurate quantification often relies on "clean" acquisitions of multiple contrasts that only depend on few parameters. These parameters are later determined by fitting the different contrasts to a signal model. Prime examples include inversion or saturation recovery measurements for determining T1 and T2, which are often considered as gold standard.

Accelerated acquisition methods frequently require trade-offs in contrast accuracy. For instance, variable flip angle, vFA, T1 mapping often relies on less precise steady states to expedite the process.

Magnetic resonance fingerprinting, MRF, is an alternative approach in qMRI, which simultaneously acquires multiple parameters in a single scan. Instead of isolating specific sequences for individual measurements, MRF aims to generate a "fingerprint" of tissue properties, allowing for more efficient and comprehensive quantification. The underlying idea is based on a complete Bloch simulation of the applied acquisition sequence diagram for an imaged voxel. A significant compromise in MRF lies in the calculation of the signal evolution in a given voxel from the acquired k-space data. Since many samples for the signal evolution are required and a complete optimization of the whole volume is intractable with conventional reconstruction methods, typically simple regridding reconstructions are done with high undersampling. The method relies on the hope that corresponding undersampling artifacts average out in the voxel-wise dictionary matching. Moreover, establishing standardized dictionaries and protocols across different scanners and sites is a challenge for widespread clinical adoption.

MRI simulators are software tools designed to replicate the processes and outcomes of MRI without the need for an actual MRI scanner. They work by using a model for an object and simulations to emulate the physical principles involved in MRI. Some simulators are based on solving the Bloch equations directly, as for example described in the publication of H. Benoit-Cattin et al.: "The SIMRI project: a versatile and interactive MRI simulator.", Journal of Magnetic Resonance, 173(1), 97-115.

Others rely on the extended phase graph algorithm, as explained in S. Rakshit et al.: "GPU-accelerated extended phase graph algorithm for differentiable optimization and learning." Proc. Intl. Soc. Mag. Reson. Med. 29 (2021), available at https://somnathrakshit.github.io/projects/ project-mri-sim-py-epg/3754.html (retrieved October 11, 2024).

MRzero is a comprehensive framework that emulates an MRI pipeline, encompassing sequence and phantom definition, signal simulation, and image reconstruction, as described in A. Loktyushin et al.: "MRzero - Automated discovery of MRI sequences using supervised learning.", Magnetic Resonance in Medicine, 86: 709-724 and H. Dang et al.: "MR-zero meets RARE MRI: Joint optimization of refocusing flip angles and neural networks to minimize T2-induced blurring in spin echo sequences.", Magnetic Resonance in Medicine, 90(4): 1345-1362. At its core, MRzero incorporates a phase distribution graph, PDG, simulator inspired by the EPG concept, as described in J. Endres et al.: "Phase distribution graphs for fast, differentiable, and spatially encoded Bloch simulations of arbitrary MRI sequences." Magnetic Resonance in Medicine, 92, 10.

Sequence descriptions for MRI acquisition sequences can, for example, be provided in the form of files following the pulseq standard, as described in K.J. Layton et al.: "Pulseq: A rapid and hardware-independent pulse sequence prototyping framework." Magnetic Resonance in Medicine, 77(4): 1544-1552.

It is an objective of the present invention to provide a concept for determining a quantitative material characterization of an object based on MRI data, wherein conventional qualitative MRI acquisition sequences may be used.

This objective is achieved by the subject matter of the independent claim. Preferred embodiments and further implementations are subject matter of the dependent claims.

The invention is based on the idea to simulate MRI data according to at least two acquisition sequences based on a model for the object to be imaged and to iteratively adapt the model based on a deviation of the simulated MRI data from the respective measured MRI data.

According to an aspect of the invention, a computer-implemented method for determining a quantitative material characterization of an object is provided. Therein, first measured magnetic resonance imaging, MRI, data representing the object is received and a first sequence description specifying a first acquisition sequence used for generating the first measured MRI data is received. Second measured MRI data representing the object is received and a second sequence description specifying a second acquisition sequence used for generating the second measured MRI data is received, wherein the second acquisition sequence is, in particular, different from the first acquisition sequence. For each iteration of two or more iterations, the following steps i) to iv) are carried out.

In step i), first simulated MRI data is generated by simulating an MRI acquisition according to the first sequence description based on a model for the object comprising respective model values for at least one material parameter of the object. In step ii), second simulated MRI data is generated by simulating an MRI acquisition according to the second sequence description based on the model. In step iii), an error is determined, which depends on a deviation of the first simulated MRI data from the first measured MRI data and on a deviation of the second simulated MRI data from the second measured MRI data. In step iv), the model is adapted by adapting the model values depending on the error.

The two or more iterations comprise an initial iteration and a final iteration. Optionally, the two or more iterations comprise one or more subsequent intermediate iterations following the initial iteration and the final iteration follows the intermediate iterations in this case. If the respective iteration corresponds to the initial iteration, the model of the respective iteration corresponds to an initial model for the object comprising respective predefined initial model values for the at least one material parameter, and otherwise the model of the respective iteration corresponds to the adapted model of a respective preceding iteration.

In other words, the model used in steps i) and ii) of the initial iteration is the initial model and the model used in steps i) and ii) of the final iteration and, if applicable, the one or more intermediate iterations, is the adapted model of the respective preceding iteration.

The quantitative material characterization is determined depending on the adapted model of the final iteration of the two or more iterations. In particular, the quantitative material characterization is given by the adapted model of the final iteration or by the at least one material parameter of the adapted model of the final iteration or the quantitative material characterization is computed or derived from the at least one material parameter of the adapted model.

Unless stated otherwise, all steps of the computer-implemented method may be performed by a data processing system, which comprises at least one data processing device. In particular, the at least one data processing device is configured or adapted to perform the steps of the computer-implemented method. For this purpose, the at least one data processing device may for example store a computer program comprising instructions which, when executed by the at least one data processing device, cause the at least one data processing device to execute the computer-implemented method. The expressions "data processing system" and "at least one data processing device" may be used interchangeably, here and in the following. This holds also for respective expressions derived therefrom.

In case the at least one data processing device comprises two or more data processing devices, certain steps carried out by the at least one data processing device may also be understood such that different data processing devices carry out different steps or different parts of a step. In particular, it is not required that each data processing device carries out the steps completely. In other words, carrying out the steps may be distributed amongst the two or more data processing devices.

It is noted that generating the first and the second measured MRI data is not part of the computer-implemented method according to the invention. However, from each implementation of the computer-implemented method, a respective implementation of a method for determining a quantitative material characterization of an object, which is not purely computer-implemented, is obtained by including respective steps of generating the first and the second measured MRI data. Such a method may also be denoted as method for quantitative MRI, qMRI.

The total number of the two or more iterations is not necessarily predefined. In particular, the two or more iterations may be terminated after the final iteration of the two or more iterations, wherein the error of the final iteration is equal to or less than a predefined maximum error.

In other words, it may be provided that, if it is found in any iteration except for the initial iteration that the error computed in step iii) of the respective iteration is equal to or less than the maximum error, then said iteration is the final iteration by definition and no further iteration is carried out.

In other words, carrying out the two or more iterations corresponds to an optimization of an objective function, which is given by or depends on the error, wherein the at least one material parameter corresponds to the optimization variable or optimization variables. The exact way how the at least one material parameter is adapted to adapt the model depends on the actual optimization method used. Known optimization methods like gradient descent methods may be used, for example.

Here and in the following, measured MRI data can be understood as data, which is generated by an MRI device applying a respective MRI acquisition sequence while the object is located in the respective target region of the MRI device. The acquisition sequences, in particular the first acquisition sequence and the second acquisition sequence, are not necessarily specifically adapted for the purpose of qMRI. In particular, the acquisition sequences, in particular the first acquisition sequence and the second acquisition sequence, are not specifically adapted for the purpose of qMRI but correspond to conventional MRI acquisition sequences or, in other words, to MRI acquisition sequences for qualitative MRI.

Here and in the following, simulated MRI data can be understood as data, which is generated by a computer algorithm, which may be implemented in software and/or in hardware, which is adapted or designed, given the respective sequence description, to simulate the physical processes of the MR measurement for the object based on the model for the object. The computer algorithm may for example be denoted as an MRI simulator. A known MRI simulator, for example one of the MRI simulators mentioned in the introductory part of the present disclosure, may be used for this purpose. The respective sequence description, in particular the first sequence description and the second sequence description, may for example be provided according to the pulseq standard or according to another suitable standard.

The exact form of the model may depends on the actually used MRI simulator. For example, the model may comprise or be given by a respective three-dimensional parameter map for each material parameter of the at least one material parameter comprising the respective model values. In particular, the model, for example the three-dimensional parameter maps, may describe the spatial distribution of the values for each of the at least one material parameter for the object. The initial model or the initial model values, respectively, may be predefined default values, for example assuming a constant spatial distribution of the at least one material parameter within the object. Alternatively, more realistic estimated or empirically determined spatial distributions may be used for the initial model.

The original purpose of MRI simulators is to obtain an estimation for MRI data representing an object without requiring an MRI device starting from a given model for the object. By means of the computer-implemented method according to the invention, however, the MRI simulator is used in an inverse manner. Rather than obtaining suitable simulated MRI data, the purpose of the MRI simulator in the computer-implemented method according to the invention is to iteratively deliver the optimal model for the object given the real measured MRI data. The model obtained in this way then allows to evaluate the at least one material parameter quantitatively without using acquisition sequences specifically designed for the purpose of qMRI.

It is noted that the inversion of the MRI simulator is, in general, not a well-posed problem. Therefore, the computer-implemented method according to the invention uses at least two different sets of measured MRI data and correspondingly two different sets of simulated MRI data for the optimization, wherein the error or, in other words, the objective function, depends on both respective deviations between measured and simulated MRI data. Thus, the accuracy of the approach is increased significantly.

In particular, the first measured MRI data may origin from an arbitrary clinical MRI scan. The second acquisition sequence may then be selected in a case specific manner to make sure that the second measured MRI data comprise as much information as possible that is not present in the first MRI data. To achieve this, multiple sequence parameters for the second acquisition sequence may be adapted including, but not limited to, the echo time, the repetition time, the type of the sequence, the physical mechanism of generating the echoes, in particular sequences based gradient echoes versus sequences based on spin echoes, the number of certain HF-pulses, the temporal distance between HF-pulses and so forth. In general, any sequence parameter, which changes the resulting MRI data, may be altered in the second acquisition sequence compared to the first acquisition sequence.

The method according to the invention relies on using different acquisition sequences for the first and the second measured MRI data. The more the first measured MRI data and the second measured MRI data differ from each other or, in other words, complement each other in terms of their information content, the higher will be the accuracy of the result. It may also be subject to experiments, how exactly the second acquisition sequence shall be chosen given the first acquisition sequence.

The accuracy and/or reliability of the method may be further increased by taking into account one or more further acquisitions.

According to several embodiments, third measured MRI data representing the object is received and a third sequence description specifying a third acquisition sequence used for generating the third measured MRI data is received, wherein the third acquisition sequence is, in particular, different from the first acquisition sequence and different from the second acquisition sequence. For each iteration of the two or more iterations, third simulated MRI data is generated by simulating an MRI acquisition according to the third sequence description based on the model of the respective iteration. The error is determined depending on a deviation of the third simulated MRI data from the third measured MRI data.

In an analog manner, further embodiments based on respective further measured MRI data representing the object and respective further sequence descriptions specifying respective acquisition sequences used for generating the respective further measured MRI data are obtained.

The explanations above and in the following regarding the first measured MRI data and the second measured MRI data hold analogously for the third measured MRI data and the further measured MRI data, as far as applicable. The explanations above and in the following regarding the first simulated MRI data and the second simulated MRI data hold analogously for the third simulated MRI data and the further simulated MRI data, as far as applicable. The explanations above and in the following regarding the first sequence description, the first acquisition sequence, the second sequence description and the second acquisition sequence hold analogously for the third sequence description, the third acquisition sequence, the respective further sequence descriptions and the respective further acquisition sequences, as far as applicable.

According to several embodiments, the first measured MRI data and the second measured MRI data are respective raw data in k-space.

In other words it is not required to reconstruct the first measured MRI data and the second measured MRI data into image space before they can be compared to the output of the MRI simulator to compute the error. Therefore, the demands on computational resources like computation time and memory are reduced.

According to several embodiments, in step iii) the respective error is computed depending on a measure of similarity or a measure of dissimilarity between the first simulated MRI data and the first measured MRI data and depending on a measure of similarity or a measure of dissimilarity between the second simulated MRI and the second measured MRI data.

According to several embodiments, in step iii) the respective error is computed depending on a mean squared error of the deviation of the first simulated MRI data from the first measured MRI data and depending on a mean squared error of the deviation of the second simulated MRI data from the second measured MRI data. For example, the error may be computed as or depending on a sum or a weighted sum of said mean squared errors.

In respective embodiments, the error is computed depending on a mean squared error of the deviation of the third simulated MRI data from the third measured MRI data and depending on a respective mean squared error of the deviation of the respective further simulated MRI data from the respective further measured MRI data, as far as applicable. For example, the error may be computed as a sum or a weighted sum of all respective mean squared errors.

According to several embodiments, in step iii) the respective error is computed depending on a L1-deviation of the first simulated MRI data from the first measured MRI data and depending on a L1-deviation of the deviation of the second simulated MRI data from the second measured MRI data. For example, the error may be computed as or depending on a sum or a weighted sum of said mean squared errors.

According to several embodiments, in step iii) the respective error is computed depending on a structural similarity, SSIM, between the first simulated MRI data and the first measured MRI data and depending on a SSIM between the second simulated MRI data and the second measured MRI data. For example, the error may be computed as or depending on a sum or a weighted sum of said mean squared errors.

According to several embodiments, a differentiable MRI simulator is applied to the model of the respective iteration and the first sequence description in order to generate the respective first simulated MRI data and the differentiable MRI simulator is applied to the model of the respective iteration and the second sequence description in order to generate the respective second simulated MRI data.

Consequently, the adaptation of the model depending on the error is simplified and for example gradient-based optimization algorithms may be used.

According to several embodiments, a type of the first acquisition sequence corresponds to a first T1-weighted MRI acquisition, a first T2-weighted MRI acquisition, a first proton density, PD, weighted MRI acquisition, a first fluid attenuated inversion recovery, FLAIR, MRI acquisition or a first diffusion weighted MRI acquisition. In particular, the first sequence description corresponds to a sequence description of the first T1-weighted MRI acquisition, the first T2-weighted MRI acquisition, the first PD-weighted MRI acquisition, the first FLAIR MRI acquisition or the first diffusion weighted MRI acquisition.

According to several embodiments, a type of the second acquisition sequence corresponds to a second T1-weighted MRI acquisition, a second T2-weighted MRI acquisition, a second PD-weighted MRI acquisition, a second FLAIR MRI acquisition or a second diffusion weighted MRI acquisition. In particular, the second sequence description corresponds to a sequence description of the second T1-weighted MRI acquisition, the second T2-weighted MRI acquisition, the second PD-weighted MRI acquisition, the second FLAIR MRI acquisition or the second diffusion weighted MRI acquisition.

The T1 relaxation time is the time constant of a process by which the net magnetization returns to its initial maximum value parallel to the main magnetic field. The T1 relaxation time is sometimes also denoted as longitudinal relaxation time, thermal relaxation time or spin-lattice relaxation time. The T2 relaxation time is the time constant of a process by which the transverse components of the magnetization decay. The T2 relaxation time is sometimes also denoted as transverse relaxation time. The T1 relaxation time for a given material is equal to or longer than the T2 relaxation time for this material. For water at a main magnetic field of 1.5T, T1 may be approximately 4000 ms and T2 approximately 2000 ms, for example. For typical biological tissues, T1 may lie in the order of a few hundred ms to 1000 ms, while T2 may lie in the order of 0.1 ms to 100 ms for the same tissues.

The echo time TE corresponds to the time from the respective RF-pulse to the resulting echo, in particular the time between the center of the RF-pulse and the center of the echo. The repetition time TR corresponds to a time period between corresponding consecutive points of a repeating series of pulses and echoes. Thus, TR is in general longer than TE.

Typical values used for TE and TR may for example lie in the order of 1 ms to 200 ms for TE and in the order of 100 ms to 4 s for TR.

The type of the acquisition refers, in particular, to the type of contrast, which may be visualized by the respective MRI data. For example, in a T1-weighted MRI acquisition, the repetition time TR and echo time TE are selected so that the examined materials are differentiated primarily by their T1 relaxation time rather than their T2 relaxation time. In other words, TR and TE are chosen such that T1 is predominantly contrast-enhancing and not T2. This is achieved by selecting a relatively short TR and a relatively short TE. Analogously, in a T2-weighted MRI acquisition, the repetition time TR and echo time TE are selected so that the examined materials are differentiated primarily by their T2 relaxation time rather than their T1 relaxation time. In other words, TR and TE are chosen such that T2 is predominantly contrast-enhancing and not T1. This is achieved by selecting a relatively long TR and a relatively long TE. A PD-weighted MRI acquisition is characterized by a relatively long TR and a relatively short TE.

For example, for a T1-weighted MRI acquisition, TE may lie in the range [1 ms, 30 ms] and TR in the range [100 ms, 700 ms]. For example, for a T2-weighted MRI acquisition, TE may lie in the range [80 ms, 200 ms] and TR in the range [1.5 s, 4 s]. For example, for a PD-weighted MRI acquisition, TE may lie in the range [1 ms, 30 ms] and TR in the range [1.5 s, 4 s].

According to several embodiments, the type of the first acquisition sequence differs from the type of the second acquisition sequence, in particular according to the first and the second sequence description.

In such embodiments, the difference between the first acquisition sequence and the second acquisition sequence is particularly pronounced. Thus, the accuracy of the optimization result is increased.

For example, the first acquisition sequence may be a T1-weighted acquisition sequence, while the second acquisition sequence is a T2-weighted acquisition sequence or a PD-weighted acquisition sequence or a FLAIR acquisition sequence or a diffusion weighted acquisition sequence. In further examples, the first acquisition sequence may be a T2-weighted acquisition sequence, while the second acquisition sequence is a T1-weighted acquisition sequence or a PD-weighted acquisition sequence or a FLAIR acquisition sequence or a diffusion weighted acquisition sequence. In further examples, the first acquisition sequence may be a PD-weighted acquisition sequence, while the second acquisition sequence is a T1-weighted acquisition sequence or a T2-weighted acquisition sequence or a FLAIR acquisition sequence or a diffusion weighted acquisition sequence. In further examples, the first acquisition sequence may be a FLAIR acquisition sequence, while the second acquisition sequence is a T1-weighted acquisition sequence or a PD-weighted acquisition sequence or a T2-acquisition sequence or a diffusion weighted acquisition sequence. In further examples, the first acquisition sequence may be a diffusion weighted acquisition sequence, while the second acquisition sequence is a T1-weighted acquisition sequence or a PD-weighted acquisition sequence or a T2-acquisition sequence or a FLAIR acquisition sequence.

According to several embodiments, the first sequence description specifies a first echo time and the second sequence description specifies a second echo time, which is different from the first echo time. Alternatively or in addition, the first sequence description specifies a first repetition time and the second sequence description specifies a second repetition time, which is different from the first repetition time.

In such embodiments, the type of the first acquisition sequence and the type of the second acquisition sequence may be the same or may differ from each other. In particular, the difference between the first acquisition sequence and the second acquisition sequence is particularly pronounced. Thus, the accuracy of the optimization result is increased. Therein, the echo time and the repetition time are particularly well suited for differentiating the first acquisition sequence from the type of the second acquisition sequence, since they can be adapted easily within the respective allowable range.

According to several embodiments, the model for the object comprises a respective spatially resolved parameter map for each material parameter of the at least one material parameter.

The spatially resolved parameter map may for example be a three-dimensional parameter map. In this case, the spatially resolved parameter map for a certain material parameter comprises a respective value for said material parameter for each of a plurality of voxels representing the spatial extension of the object or a part of it.

Adapting the model values depending on the error in step iv) of a given iteration corresponds to adapting the respective values of each material parameter of the at least one material parameter for each of the plurality of voxels depending on the error. Obviously, this does not mean that every value of every voxel for each material parameter is necessarily changed.

In such embodiments, the object is modelled in a very detailed manner and the quantitative material characterization provides a large amount of information regarding the spatial structure of the object and the potential materials comprised by the object.

In particular, the quantitative material characterization comprises the respective spatially resolved parameter map for each material parameter of the at least one material parameter of the adapted model of the final iteration.

According to several embodiments, the at least one material parameter comprises a T1-relaxation time and/or a T2-relaxation time and/or a T2*-relaxation time and/or a proton density and/or an apparent diffusion coefficient.

In other words, the model for the object comprises a T1-relaxation time, for example a spatially resolved T1-map, and/or a T2-relaxation time, for example a spatially resolved T2-map, and/or a T2*-relaxation time, for example a spatially resolved T2*-map, and/or a proton density, for example a spatially resolved PD-map, and/or an apparent diffusion coefficient, for example a spatially resolved map of the apparent diffusion coefficient.

According to a further aspect of the invention, a method for quantitative MRI, qMRI, is provided. Therein, first measured MRI data representing an object is generated by an MRI device according to a predefined first acquisition sequence and second measured MRI data representing the object is generated by the MRI device according to a predefined second acquisition sequence. A computer-implemented method according to the invention is carried out.

Further implementations of the method for qMRI according to the invention follow directly from the various embodiments of the computer-implemented method according to the invention and vice versa. In particular, individual features and corresponding explanations as well as advantages relating to the various implementations of the computer-implemented method according to the invention can be transferred analogously to corresponding implementations of the method for qMRI according to the invention.

According to a further aspect of the invention, a data processing system that is configured to carry out a computer-implemented method according to the invention is provided.

In the present disclosure, the terms "data processing system" and "at least one data processing device" can be used interchangeably. In particular, a data processing device can be understood to mean a data processing device that contains a processing circuit. The data processing device can therefore, in particular, process data for the purpose of performing computing operations. This may also include operations for performing indexed access to a data structure, for example a look-up table, LUT, as well as a data processing method implemented in hardware.

The data processing device may include, in particular, one or more computers, one or more microcontrollers and/or one or more integrated circuits, for example one or more application-specific integrated circuits, ASIC, one or more field-programmable gate arrays, FPGA, and/or one or more systems-on-a-chip, SoC. The data processing device may also include one or more processors, for example one or more microprocessors, one or more central processing units, CPUs, one or more graphics processing units, GPUs, and/or one or more signal processors, in particular one or more digital signal processors, DSPs. The data processing device may also include a physical or virtual network of computers or other of the mentioned units.

In various embodiments, the data processing device includes one or more hardware and/or software interfaces and/or one or more storage units.

A storage unit may be a volatile data memory, for example a dynamic random access memory, DRAM, or a static random access memory, SRAM, or a non-volatile data memory, for example a read-only memory, ROM, a programmable read-only memory, PROM, an erasable programmable read-only memory, EPROM, an electrically erasable programmable read-only memory, EEPROM, a flash memory or flash EEPROM, a ferroelectric random access memory, FRAM, a magnetoresistive random access memory, MRAM, or a phase-change random access memory, PCRAM.

According to a further aspect of the invention, an MRI system is provided. The MRI system comprises a data processing system according to the invention and an MRI device. The MRI device is configured to generate the first measured MRI data according to the first acquisition sequence and the second measured MRI data according to the second acquisition sequence.

According to a further aspect of the invention, a first computer program comprising first instructions is provided. When the first instructions are executed by a data processing system, the first instructions cause the data processing system to carry out a computer-implemented method according to the invention.

The first instructions may be provided as program code, for example. The program code can for example be provided as binary code or assembler and/or as source code of a programming language, for example C, and/or as program script, for example Python.

According to a further aspect of the invention, a second computer program comprising second instructions is provided. When the second instructions are executed by an MRI system according to the invention, in particular by the data processing system of the MRI system, the second instructions cause the MRI system to carry out a method for qMRI according to the invention.

The second instructions may be provided as program code, for example. The program code can for example be provided as binary code or assembler and/or as source code of a programming language, for example C, and/or as program script, for example Python.

According to a further aspect of the invention, a computer-readable storage medium, in particular a tangible and/or non-transient computer readable storage medium, storing a first computer program and/or a second computer program according to the invention is provided.

The first computer program, the second computer program and the computer-readable storage medium are respective computer program products comprising the first instructions and/or the second instructions.

Further features and feature combinations of the invention are obtained from the figures and their description as well as the claims. In particular, further implementations of the invention may not necessarily contain all features of one of the claims. Further implementations of the invention may comprise features or combinations of features, which are not recited in the claims.

In the following, the invention will be explained in detail with reference to specific exemplary implementations and respective schematic drawings. In the drawings, identical or functionally identical elements may be denoted by the same reference signs. The description of identical or functionally identical elements is not necessarily repeated with respect to different figures.

In the figures,
- FIG 1: shows schematically an exemplary embodiment of an MRI system according to the invention; and
- FIG 2: shows a schematic block diagram of an exemplary embodiment of a computer-implemented method for determining a quantitative material characterization of an object according to the invention.

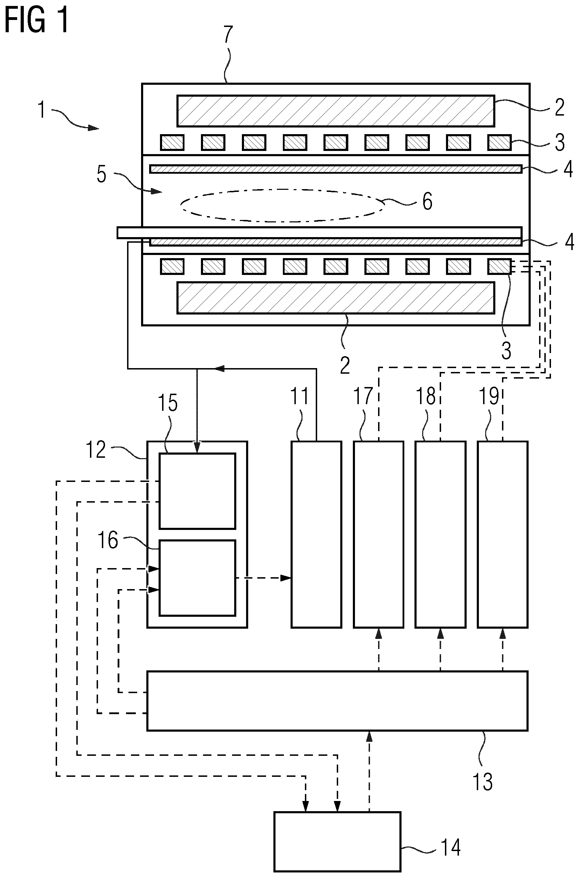

FIG 1 shows schematically an exemplary embodiment of an MRI system 1 according to the invention. The MRI system 1 comprises an MRI device 7, which is configured to generate first measured MRI data 20 representing an object 6 according to a predefined first acquisition sequence and second measured MRI data 23 according to a predefined second acquisition sequence. The MRI system 1 further comprises a data processing system 14 according to the invention, which is configured to carry out a computer-implemented method for determining a quantitative material characterization of the object 6 according to the invention based on the first measured MRI data 20 and the second measured MRI data 23.

The MRI device 7 comprises a housing defining a bore 5 and a main magnet arrangement 2, which is configured to generate a main magnetic field, also denoted as polarizing magnetic field, within the bore 5. The MRI device 7 comprises an RF system 4, 11, 12, which is configured to apply RF pulses to the object 6, in particular a body part of a patient, disposed within the bore 5, and to receive MR signals emitted from the target material. For example, the main magnet arrangement 2 may generate a uniform main magnetic field B0 as the main magnetic field and at least one RF coil 4 of the RF system 4, 11, 12 may emit an excitation field B1.

According to MR techniques, the object 6 is subjected to the main magnetic field, causing the nuclear spins in the target material to process about the direction of the main magnetic field at their characteristic Larmor frequency. A net magnetic moment Mz is produced in the direction z of the main magnetic field, and the randomly oriented magnetic moments of the nuclear spins cancel out one another in the x-y-plane.

When the object 6 is then subjected to the transmit RF magnetic field, which is for example in the x-y plane and near the Larmor frequency, the net magnetic moment rotates out of the z-direction generating a net in-plane magnetic moment, whose projection rotates in the x-y plane with the Larmor frequency. In response, MR signals are emitted by the excited spins when they return to their state before the excitation. The emitted MR signals are detected, for example by the at least one RF coil 4 and/or one or more dedicated detection coils, digitized in a receiver channel 15 of an RF controller 12 of the RF system 4, 11, 12, and may be processed, for example by the data processing system 14, to reconstruct an MR image using for example a known reconstruction technique.

In particular, gradient coils 3 of the MRI device 7 may produce magnetic field gradients Gx, Gy, and Gz for position-encoding of the MR signals. Accordingly, MR signals are emitted only by such nuclei of the target material, which correspond to the particular Larmor frequency. For example, Gz is used together with a bandwidth-limited RF pulse to select a slice perpendicular to the z-direction and consequently may also be denoted as slice selection gradient. In alternative examples, Gx, Gy, and Gz may be used in any predefined combination with a bandwidth-limited RF pulse to select a slice perpendicular to the vector sum of said gradient combination. The gradient coils 3 may be supplied with current by respective amplifiers 17, 18, 19 for generating the respective gradient fields in x-direction, y-direction, and z-direction, respectively. Each amplifier 17, 18, 19 may include a respective digital-to-analog converter, which is controlled by a sequence controller 13 to generate respective gradient pulses at predefined time instances.

The sequence controller 13 may control the generation of RF pulses by an emitter channel 16 of the RF controller 12 and an RF power amplifier 11 of the RF system 4, 11, 12.

The data processing system 14 may receive the real and imaginary parts from analog-digital converters of the receiver channel 15 and reconstruct the MR image based on them according to a known technique.

It is noted that the components of the MRI device 7 can also be arranged differently from the arrangement shown in FIG 1. For example, the gradient coils 3 may be arranged inside the bore 5, similar as shown for the at least one RF coil 4. It is further noted that each component of the MRI device 7 may include other elements which are required for the operation thereof, and/or additional elements for providing functions other than those described in the present disclosure.

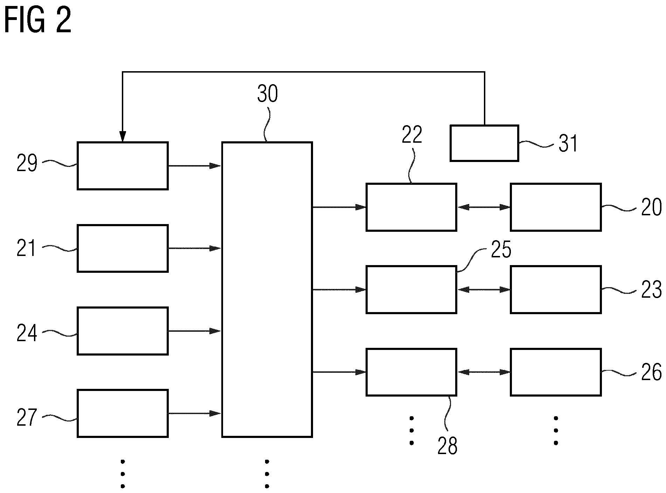

FIG 2 shows a schematic block diagram of an exemplary embodiment of a computer-implemented method for determining a quantitative material characterization of the object 6 according to the invention.

Therein, the first measured MRI data 20 and a first sequence description 21, for example according to the pulseq standard, specifying a first acquisition sequence used for generating the first measured MRI data 20 is received. Furthermore, the second measured MRI data 23 and a second sequence description 24 specifying a second acquisition sequence used for generating the second measured MRI data 23 is received.

A model 29 for the object 6 comprising respective model values for at least one material parameter of the object 6 is received, in particular an initial version of the model 29 comprising respective predefined initial model values for the at least one material parameter. The at least one material parameter comprises, for example, a T1-relaxation time and/or a T2-relaxation time and/or a T2*-relaxation time and/or a proton density PD and/or an apparent diffusion coefficient. In particular, the model 29 comprises a respective spatially resolved parameter map for each material parameter of the at least one material parameter.

Furthermore, an MRI simulator 30, in particular a differential MRI simulator 30, is provided. The MRI simulator 30 is, for example, a software tool, which designed to simulate respective MRI data based on the model 29 and a corresponding sequence description. Thus, the MRI simulator 30 is used to optimize an objective function, which depends on respective deviations between the measured MRI data 20, 23 and the corresponding simulated MRI data 22, 25, iteratively by varying the model 29, in particular the values of the spatially resolved parameter maps.

To this end, for each iteration of two or more iterations, steps i) to iv) are carried out, wherein in step i), the first simulated MRI data 22 is generated by the MRI simulator 30 by simulating an MRI acquisition according to the first sequence description 21 based on the model 29 of the respective iteration. In step ii), the second simulated MRI data 25 is generated by the MRI simulator 30 by simulating an MRI acquisition according to the second sequence description 24 based on the model 29. In step iii), an error 31 is determined, which depends on a deviation of the first simulated MRI data 22 from the first measured MRI data 20 and on a deviation of the second simulated MRI data 25 from the second measured MRI data 23. In step iv), the model 29 is adapted by adapting the model values depending on the error 31.

In the two or more iterations, the model 29 corresponds to the predefined initial version of the model 29 for an initial iteration of the two or more iterations. For all other iterations of the two or more iterations, the model 29 of the respective iteration corresponds to the adapted model 29 of the respective preceding iteration. The quantitative material characterization is determined depending on the adapted model 29 of a final iteration of the two or more iterations. In particular, the iterations are continued until the error 31 is equal to or less than a predefined maximum error. The corresponding iteration where this is the case is the final iteration of the two or more iterations.

It is noted that the described method may, in respective iterations, be extended to include further measured MRI data and corresponding further simulated MRI data and process them in the same way as explained for the first and second measured MRI data 20, 23 and the first and second simulated MRI data 22, 25, respectively. The error 31 then depends on all respective deviations between the measured MRI data and the simulated MRI data.

This is indicated for third measured MRI data 26 in FIG 2. In this case, the third measured MRI data 26 and a third sequence description 27 specifying a third acquisition sequence used for generating the third measured MRI data 26 are received. For each iteration of the two or more iterations, third simulated MRI data 28 is generated by the MRI simulator 30 by simulating an MRI acquisition according to the third sequence description 27 based on the model 29 of the respective iteration. The error 31 is determined depending on a deviation of the third simulated MRI data 28 from the third measured MRI data 26.

Independent of the grammatical term usage, individuals with male, female or other gender identities are included within the term.

## Claims

1. Computer-implemented method for determining a quantitative material characterization of an object (6), wherein
- first measured magnetic resonance imaging, MRI, data (20, 23, 26) representing the object (6) is received and a first sequence description (21, 24, 27) specifying a first acquisition sequence used for generating the first measured MRI data (20, 23, 26) is received;
- second measured MRI data (20, 23, 26) representing the object (6) is received and a second sequence description (21, 24, 27) specifying a second acquisition sequence used for generating the second measured MRI data (20, 23, 26) is received;
- for each iteration of two or more iterations
i) first simulated MRI data (22, 25, 28) is generated by simulating an MRI acquisition according to the first sequence description (21, 24, 27) based on a model (29) for the object (6) comprising respective model values for at least one material parameter of the object (6);
ii) second simulated MRI data (22, 25, 28) is generated by simulating an MRI acquisition according to the second sequence description (21, 24, 27) based on the model (29);
iii) an error (31) is determined, which depends on a deviation of the first simulated MRI data (22, 25, 28) from the first measured MRI data (20, 23, 26) and on a deviation of the second simulated MRI data (22, 25, 28) from the second measured MRI data (20, 23, 26); and
iv) the model (29) is adapted by adapting the model values depending on the error (31);
- if the respective iteration corresponds to an initial iteration of the two or more iterations, the model (29) of the respective iteration corresponds to an initial model (29) for the object (6) comprising respective predefined initial model values for the at least one material parameter, and otherwise the model (29) of the respective iteration corresponds to the adapted model (29) of a respective preceding iteration; and
- the quantitative material characterization is determined depending on the adapted model (29) of a final iteration of the two or more iterations.

2. Computer-implemented method according to claim 1, wherein a type of the first acquisition sequence differs from a type of the second acquisition sequence.

3. Computer-implemented method according to claim 2, wherein
- the type of the first acquisition sequence corresponds to a first T1-weighted MRI acquisition, a first T2-weighted MRI acquisition, a first proton density, PD, weighted MRI acquisition, a first fluid attenuated inversion recovery, FLAIR, MRI acquisition or a first diffusion weighted MRI acquisition; and/or
- the type of the second acquisition sequence corresponds to a second T1-weighted MRI acquisition, a second T2-weighted MRI acquisition, a second PD-weighted MRI acquisition, a second FLAIR MRI acquisition or a second diffusion weighted MRI acquisition.

4. Computer-implemented method according to one of the preceding claims, wherein
- the first sequence description (21, 24, 27) specifies a first echo time and the second sequence description (21, 24, 27) specifies a second echo time, which is different from the first echo time; and/or
- the first sequence description (21, 24, 27) specifies a first repetition time and the second sequence description (21, 24, 27) specifies a second repetition time, which is different from the first repetition time.

5. Computer-implemented method according to one of the preceding claims, wherein the model (29) for the object (6) comprises a respective spatially resolved parameter map for each material parameter of the at least one material parameter.

6. Computer-implemented method according to one of the preceding claims, wherein the at least one material parameter comprises a T1-relaxation time and/or a T2-relaxation time and/or a T2*-relaxation time and/or a proton density and/or an apparent diffusion coefficient.

7. Computer-implemented method according to one of the preceding claims, wherein in step i), a differentiable MRI simulator (30) is applied to the model (29) of the respective iteration and the first sequence description (21, 24, 27) in order to generate the respective first simulated MRI data (22, 25, 28) and the differentiable MRI simulator (30) is applied to the model (29) of the respective iteration and the second sequence description (21, 24, 27) in order to generate the respective second simulated MRI data (22, 25, 28).

8. Computer-implemented method according to one of the preceding claims, wherein in step iii), the respective error (31) is computed depending on a mean squared error of the deviation of the first simulated MRI data (22, 25, 28) from the first measured MRI data (20, 23, 26) and depending on a mean squared error of the deviation of the second simulated MRI data (22, 25, 28) from the second measured MRI data (20, 23, 26).

9. Computer-implemented method according to one of the preceding claims, wherein the two or more iterations are terminated after the final iteration of the two or more iterations, wherein the error (31) of the final iteration is equal to or less than a predefined maximum error.

10. Computer-implemented method according to one of the preceding claims, wherein the first measured MRI data (20, 23, 26) and the second measured MRI data (20, 23, 26) are respective raw data in k-space.

11. Computer-implemented method according to one of the preceding claims, wherein
- third measured MRI data (20, 23, 26) representing the object (6) is received and a third sequence description (21, 24, 27) specifying a third acquisition sequence used for generating the third measured MRI data (20, 23, 26) is received;
- for each iteration of the two or more iterations, third simulated MRI data (22, 25, 28) is generated by simulating an MRI acquisition according to the third sequence description (21, 24, 27) based on the model (29) of the respective iteration and the error (31) is determined depending on a deviation of the third simulated MRI data (22, 25, 28) from the third measured MRI data (20, 23, 26).

12. Method for quantitative MRI, wherein
- first measured MRI data (20, 23, 26) representing an object (6) is generated by an MRI device according to a predefined first acquisition sequence and second measured MRI data (20, 23, 26) representing the object (6) is generated by the MRI device according to a predefined second acquisition sequence; and
- a computer-implemented method according to one of the preceding claims is carried out.

13. Data processing system (14), which is configured to carry out a computer-implemented method according to one of claims 1 to 11.

14. MRI system (1) comprising a data processing system (14) according to claim 13 and an MRI device, which is configured to generate the first measured MRI data (20, 23, 26) according to the first acquisition sequence and the second measured MRI data (20, 23, 26) according to the second acquisition sequence.

15. Computer program product comprising
- first instructions, which, when carried out by a data processing system (14), cause the data processing system (14) to carry out a computer-implemented method according to one of claims 1 to 11; and/or
- second instructions, which, when carried out by an MRI system (1) according to claim 14, cause the MRI system (1) to carry out a method according to claim 12.
